(19) **Europäisches Patentamt**

**European Patent Office**

**Office européen des brevets**

(11) **EP 0 687 741 B1**

(12) **EUROPEAN PATENT SPECIFICATION**

(45) Date of publication and mention
of the grant of the patent:
**13.08.1997 Bulletin 1997/33**

(51) Int Cl.$^6$: **C22C 19/05**, C30B 11/00,
C30B 29/52

(21) Application number: **95304160.5**

(22) Date of filing: **15.06.1995**

(54) **Alloy**

Legierung

Alliage

(84) Designated Contracting States:
**DE FR GB**

(30) Priority: **16.06.1994 ZA 9404298**

(43) Date of publication of application:
**20.12.1995 Bulletin 1995/51**

(73) Proprietor: **CSIR**
**Pretoria Transvaal Province (ZA)**

(72) Inventor: **Stander, Cornelius Marthinus**
**Constantia Park, Pretoria (ZA)**

(74) Representative: **Gaunt, Robert John**
**Stevens, Hewlett & Perkins**
**1 Serjeants' Inn**
**Fleet Street**
**London EC4Y 1LL (GB)**

(56) References cited:
**EP-A- 0 240 451**        **GB-A- 2 235 697**

- **JOURNAL OF MATERIALS ENGINEERING AND PERFORMANCE, vol. 3, no. 1, February 1944 MATERIALS PARK US, pages 73-81, XP 000452177 A. SENGUPTA ET AL 'TENSILE BEHAVIOR OF A NEW SINGLE-CRYSTAL NICKEL-BASED SUPERALLOY (CMSX-4) AT ROOM AND ELEVATED TEMPERATURE'**
- **JOURNAL OF MATERIALS ENGINEERING AND PERFORMANCE, vol. 2, no. 4, August 1993 MATERIALS PARK US, pages 481-487, XP 000394071 K. HARRIS ET AL 'DEVELOPMENT OF TWO RHENIUM-CONTAINING SUPERALLOYS FOR SINGLE-CRYSTAL BLADE AND DIRECTIONALLY SOLIDIFIED VANE APPLICATIONS IN ADVANCED TURBINE ENGINES'**

# EP 0 687 741 B1

**Description**

THIS INVENTION relates to an alloy. It relates also to a component cast from the alloy, and to a method of making such component.

According to a first aspect of the invention, there is provided an alloy which comprises, on a mass percentage basis,

| Al | 5,2 - 5,8 |
|----|-----------|
| Co | 7,95 - 8,25 |
| Cr | 4,65 - 4,95 |
| Hf | 0,02 - 0,12 |
| Mo | 0,9 - 1,2 |
| Nb | 1,2 - 1,4 |
| Re | 2,9 - 4,1 |
| Ta | 7,0 - 7,3 |
| W | 7,3 - 7,7 |

with the balance being Ni. More particularly, the alloy may comprise, on a mass percentage basis,

| Al | 5,4 |
|----|-----|
| Co | 8,1 |
| Cr | 4,8 |
| Hf | 0,02 |
| Mo | 1,0 |
| Nb | 1,4 |
| Re | 3,9 |
| Ta | 7,2 |
| W | 7,6 |

with the balance being Ni.

The nickel-based superalloy of the invention is particularly suitable for casting single crystal components for use in high stress and high temperature applications, such as gas turbine components, particularly, but not exclusively, gas turbine blades and vanes, eg for use in high performance land based turbine engines having high thermodynamic efficiency, where high resistance to creep at high temperature is important.

A large number of factors need to be considered when formulating an alloy having practical single crystal castability and heat treatment properties as well as desired creep properties. The two sets of properties ie superior creep strength properties and practical manufacturing characteristics both need to be optimised.

One of the problems encountered is that of making an alloy having the desired resistance to creep, and simultaneously assuring a sufficiently large temperature range for complete solutioning of the gamma prime ("γ") phase, without the occurrence of incipient melting. This heat treatment temperature range or "window" should typically be greater than 15°C, and extends from the so called solvus temperature, which is the temperature above which solutioning of the gamma prime phase is complete, to the so called solidus temperature, which is the temperature at which incipient melting takes place. A further problem that arises is that of attaining a large enough temperature range for efficient casting of the single crystal component. This implies that the difference between the solidus temperature, at which incipient melting takes place, and the so called liquidus temperature, at which the liquid alloy solidifies or freezes, should typically be larger than 15°C. Other factors of importance are resistance to oxidation and corrosion, and the absence or presence of phases that have a deleterious effect on the creep properties of the alloy.

Thus, the alloy of the invention has the property that the primary gamma prime phase thereof can be completely solutioned without incipient melting. Furthermore, the alloy has the capability to withstand a stress of 420 MPa at 900°C for an average duration of 350 hours before undergoing a creep of 1%.

The alloy also has a favourable heat treatment window of approximately 50°C as well as a crystal casting window of approximately 35°C.

According to a second aspect of the invention, there is provided a component which comprises a single crystal cast body of an alloy as hereinbefore described.

The component may thus be in the form of a gas turbine blade or vane, or the like.

According to a third aspect of the invention, there is provided a method of making a component, which comprises

2

casting an alloy as hereinbefore described, into a single crystal component.

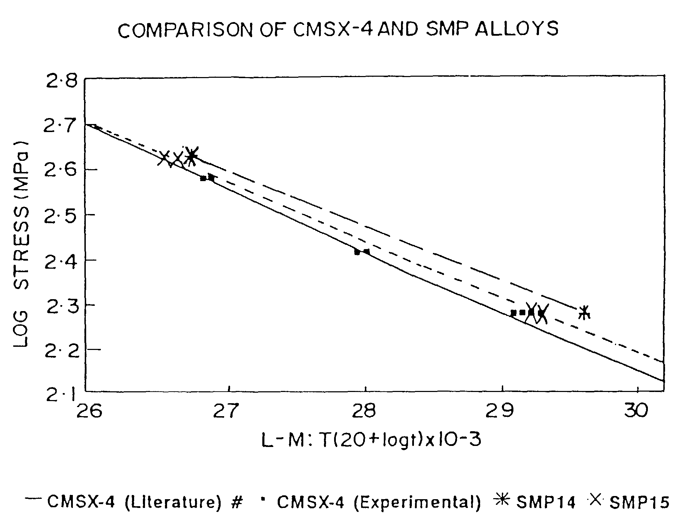

The invention will now be described in more detail with reference to the following non-limiting Example, and to the drawing which shows the dependence of the Larson-Miller parameters of various alloys on stress, given on a logarithmic basis.

EXAMPLES 1 - 4

Four alloys, designated respectively SMP12, SMP13, SMP14 and SMP15, were made up using known techniques, and the alloys chemically analysed. They were found to have the following compositions:

|     | SMP12 | SMP13 | SMP14 | SMP15 |
|-----|-------|-------|-------|-------|
| Al  | 5,97  | 5,81  | 5,37  | 5,77  |
| Co  | 8,13  | 8,11  | 8,11  | 8,09  |
| Cr  | 4,75  | 6,40  | 4,77  | 4,70  |
| Hf  | 0,02  | 0,02  | 0,02  | 0,02  |
| Mo  | 0,98  | 0,98  | 0,99  | 0,99  |
| Nb  | 1,33  | 1,35  | 1,34  | 1,27  |
| Ni  | 59,92 | 59,73 | 60,69 | 61,56 |
| Re  | 4,03  | 3,97  | 3,94  | 2,99  |
| Ta  | 7,15  | 7,12  | 7,22  | 7,07  |
| W   | 7,82  | 6,51  | 7,55  | 7,54  |

These alloys were heat treated at 870°C for 500 hours to test for any propensity to form phases that could have a detrimental effect on their creep properties. Microscopic examination of these alloys after this heat treatment revealed that alloys SMP12 and SMP13 both show the formation of unwanted chrome-rhenium sigma phase, that occurs as acicular bodies in the alloys. The presence of this phase is known to be detrimental to the creep properties of alloys. Alloys SMP14 and SMP15 have higher nickel contents than alloys SMP12 and 13 and showed no propensity to form the deleterious sigma phase. SMP14 and SMP15 are in accordance with the present invention.

Single crystal specimens of alloys SMP14 and SMP15 were cast using a thermal gradient withdrawal growth process. Creep rupture, 4mm diameter, specimens were machined from the longitudinal (001) direction, all being oriented to within 10° of this direction. The specimens were heat treated by rapid heating to a temperature just below the solvus temperature, followed by slow heating to a temperature above the solvus temperature but below the liquidus temperature. During the slow heating step the specimens are intermittently kept at constant temperature for certain time periods. A heat treatment to simulate a coating cycle was finally carried out. As an example the specimens were heat treated by ramping the temperature to 1250°C at 15°C/minute and holding at 1250°C for 1 hour, then ramping to 1270°C at 1°C/minute and holding at 1270°C for 1 hour, then ramping to 1280°C at 1°C/minute and holding at 1280°C for 1 hour, then ramping to 1290°C at 0,5°C/minute and holding at 1290°C for 1 hour, then ramping to 1300°C at 0,5°C/minute and holding at 1300°C for 1 hour, and finally ramping to 1308°C at 0,5°C/minute and holding at 1308°C for 1 hour. The samples were finally gas fan quenched. The final heat treatment consisted of a simulated coating cycle for 12 hours at 1030°C, followed by aging at 870°C for 16 hours and argon cooling.

Creep rupture tests were conducted on samples of alloys SMP14 and SMP15 and the results are shown in Table 1. The alloys of the invention (SMP14 and SMP15) achieve a significant increase in creep resistance when compared to known single crystal superalloys.

TABLE 1

| Sample | Test Condition | Time to 1% creep (hours) | Rupture time (hrs) | Strain at rupture % |
|--------|----------------|--------------------------|--------------------|---------------------|
| SMP14  | 420MPa/900°C   | 374                      | 651                | 16,6                |
| SMP14  | 420MPa/900°C   | 403                      | 691                | 16,1                |
| SMP14  | 190MPa/1050°C  | 123                      | 243                | 20,3                |
| SMP15  | 420MPa/900°C   | 212                      | 434                | 18,5                |

TABLE 1   (continued)

| Sample | Test Condition | Time to 1% creep (hours) | Rupture time (hrs) | Strain at rupture % |
|---|---|---|---|---|
| SMP15 | 420MPa/900°C | 234 | 526 | 24,0 |
| SMP15 | 190MPa/1050°C | 80 | 140 | 14,2 |

The drawing shows the dependence of the Larson-Miller parameters of various alloys on stress, given on a logarithmic basis. The Larson-Miller parameter (LM), is related to creep rupture time by the relation

$$LM = (Temperature \{°C\} + 273,2) \times (20 + \log_{10} (Time\{hour\}))$$

$$\times 10^{-3}.$$

Literature and experimental values for a known alloy designated CMSX-4, and experimental values for the alloys SMP14 and SMP15 are shown for comparison. It is evident from the drawing that the present invention results in greatly improved Larson-Miller parameters and creep strengths for the alloys SMP14 and SMP15 when compared to alloy CMSX-4.

The heat treatment "window" as well as the crystal casting "window" were determined by the Differential Thermal Analysis technique and the results for alloys SMP14 and SMP15 are shown in Table 2.

TABLE 2

| Sample | Solidus °C | Solvus °C | Heat treatment window °C | Liquidus °C | Casting window °C |
|---|---|---|---|---|---|
| SMP14 | 1341 | 1289 | 52 | 1377 | 36 |
| SMP15 | 1338 | 1292 | 46 | 1377 | 39 |

The results shown in Table 2 indicate that both the heat treatment "window" and the crystal casting "window" are satisfactory for casting crystals of good quality.

Tensile tests were conducted on samples of SMP 14, and the results are shown in Table 3.

TABLE 3

| Test temperature °C | 0,2% Proof stress (MPa) | UTS (MPa) | % Elongation | RA |
|---|---|---|---|---|
| 25 | 1060 | 1082 | 17,5 | 12,5 |
| 650 | 1002 | 1137 | 6,5 | 17 |
| 850 | 1037 | 1080 | 30 | 24 |
| 950 | 774 | 850 | 33 | 29 |

**Claims**

1. An alloy characterized in that it comprises, on a mass percentage basis,

| Al | 5,2 - 5,8 |
|---|---|
| Co | 7,95 - 8,25 |
| Cr | 4,65 - 4,95 |
| Hf | 0,02 - 0,12 |
| Mo | 0,9 - 1,2 |
| Nb | 1,2 - 1,4 |
| Re | 2,9 - 4,1 |
| Ta | 7,0 - 7,3 |
| W | 7,3 - 7,7 |

with the balance being Ni.

**2.** An alloy according to Claim 1 characterized in that it comprises, on a mass percentage basis,

| Al | 5,4 |
|----|-----|
| Co | 8,1 |
| Cr | 4,8 |
| Hf | 0,02 |
| Mo | 1,0 |
| Nb | 1,4 |
| Re | 3,9 |
| Ta | 7,2 |
| W | 7,6 |

with the balance being Ni.

**3.** A component characterized in that it comprises a single crystal cast body of an alloy according to Claim 1 or Claim 2.

**4.** A component according to Claim 3, characterized in that it is in the form of a gas turbine blade or vane.

**5.** A method of making a component, characterized in that it comprises casting an alloy according to Claim 1 or Claim 2, into a single crystal component.

**Patentansprüche**

**1.** Legierung, <u>dadurch gekennzeichnet, daß</u> sie auf Massen-Prozent-Basis umfaßt:

| Al | 5,2 - 5,8 |
|----|-----------|
| Co | 7,95 - 8,25 |
| Cr | 4,65 - 4,95 |
| Hf | 0,02 - 0,12 |
| Mo | 0,9 - 1,2 |
| Nb | 1,2 - 1,4 |
| Re | 2,9 - 4,1 |
| Ta | 7,0 - 7,3 |
| W | 7,3 - 7,7 |

Rest Ni.

**2.** Legierung nach Anspruch 1, <u>dadurch gekennzeichnet, daß</u> sie auf Massen-Prozent-Basis umfaßt:

| Al | 5,4 |
|----|-----|
| Co | 8,1 |
| Cr | 4,8 |
| Hf | 0,02 |
| Mo | 1,0 |
| Nb | 1,4 |
| Re | 3,9 |
| Ta | 7,2 |
| W | 7,6 |

Rest Ni.

**3.** Komponente, <u>dadurch gekennzeichnet, daß</u> sie einen Einkristall-Gußkörper einer Legierung nach Anspruch 1 oder Anspruch 2 umfaßt.

**4.** Komponente nach Anspruch 3, <u>dadurch gekennzeichnet, daß</u> sie in der Form einer Gasturbinenschaufel oder -flügels vorliegt.

**5.** Verfahren zur Herstellung einer Komponente, <u>dadurch gekennzeichnet, daß</u> es das Gießen einer Legierung nach Anspruch 1 oder Anspruch 2 zu einer Einkristall-Komponente umfaßt.

**Revendications**

**1.** Alliage caractérisé en ce qu'il comprend, en pourcentage en poids :

| Al | 5,2 à 5,8 |
|----|-----------|
| Co | 7,95 à 8,25 |
| Cr | 4,65 à 4,95 |
| Hf | 0,02 à 0,12 |
| Mo | 0,9 à 1,2 |
| Nb | 1,2 à 1,4 |
| Re | 2,9 à 4,1 |
| Ta | 7,0 à 7,3 |
| W | 7,3 à 7,7 |

le reste étant du Ni.

**2.** Alliage suivant la revendication 1, caractérisé en ce qu'il comprend, en pourcentage en poids :

| Al | 5,4 |
|----|-----|
| Co | 8,1 |
| Cr | 4,8 |
| Hf | 0,02 |
| Mo | 1,0 |
| Nb | 1,4 |
| Re | 3,9 |
| Ta | 7,2 |
| W | 7,6 |

le reste étant du Ni.

**3.** Composant caractérisé en ce qu'il comprend un corps coulé monocrystal d'un alliage selon la revendication 1 ou 2.

**4.** Composant selon la revendication 3, caractérisé en ce qu'il est sous la forme d'une pale ou aube de turbine à gaz.

**5.** Procédé de fabrication d'un composant caractérisé en ce qu'il consiste à couler un alliage selon la revendication 1 ou 2 en un composant monocristal.

COMPARISON OF CMSX-4 AND SMP ALLOYS

— CMSX-4 (Literature) #   · CMSX-4 (Experimental)  ✳ SMP14  ✕ SMP15